(19) Europäisches Patentamt
European Patent Office
Office européen des brevets

(11) **EP 1 898 520 B1**

(12) **EUROPEAN PATENT SPECIFICATION**

(45) Date of publication and mention
of the grant of the patent:
**14.04.2010 Bulletin 2010/15**

(51) Int Cl.:
***H03B 5/12*** *(2006.01)*

(21) Application number: **06018712.7**

(22) Date of filing: **06.09.2006**

(54) **Voltage controlled oscillator with lc resonator circuit**

Spannungsgesteuerter Oszillator mit einem LC-Schwingkreis

Oscillateur commandé en tension avec un circuit LC résonnant

(84) Designated Contracting States:
**DE FR GB**

(43) Date of publication of application:
**12.03.2008 Bulletin 2008/11**

(73) Proprietor: **Panasonic Corporation**
**Kadoma-shi**
**Osaka 571-8501 (JP)**

(72) Inventor: **Yousif, Farid**
**21337 Lüneburg (DE)**

(74) Representative: **UEXKÜLL & STOLBERG**
**Patentanwälte**
**Beselerstrasse 4**
**22607 Hamburg (DE)**

(56) References cited:
**WO-A-00/54405**

## Description

The present invention is related in general to a voltage-controlled oscillator (VCO) using an LC resonator circuit, and in particular to a wide-band low-phase-noise VCO based on LC circuits, microstrip inductors and varactor diodes. According to another aspect, the invention relates to an LC resonator adapted for use in a voltage-controlled oscillator or similar devices.

Voltage-controlled oscillators, and in particular LC based ones are well known for their use in a large spectrum of applications for generating periodical signals. When they are used in high frequency applications, such as wireless communication devices, mobile phones and transceivers, they must provide a very good stability of the periodic signals, and they must be controllable over a very wide frequency range to cover different frequency bands.

LC based voltage-controlled oscillators are preferred in high frequency applications because of their frequency accuracy and the reduced phase noise they exhibit. They have low cost and reduced size as they can be integrated in Monolithic Microwave Integrated Circuits (MMICs). LC based oscillators have mainly active elements like bipolar junction transistors (BJTs) and field effect transistors (FETs) as well as varactor diodes. The function of the LC circuit is to determine the oscillation frequency.

There is a general trend towards miniaturization of portable electronic devices, including portable wireless devices. Thus, it is required for voltage-controlled oscillators (VCOs) to be small and have light weight as well as low current consumption and low voltage operation. A synthesizer is variable frequency oscillation circuit which can be controlled to generate certain transmitting and receiving frequencies of a wireless communication system, such as mobile phones and basestations. The VCO and the phase-locked loop (PLL) are the core of any frequency synthesizer.

In general, the dynamic operating range and noise performance of a VCO may limit or affect the performance of the device in which the VCO is employed. The quality factor (Q-factor) of the resonator of the VCO affects the noise performance of the VCO. Furthermore, the loaded Q is in general inversely proportional to the operating frequency range of the VCO. Despite the continuous improvement in VCO technology, low phase noise typically remains a bottle-neck and poses a challenge to VCO design. This is typically considered due to the more demanding parameters of the VCO design: low phase noise, good stability, low-power consumption, low operating voltage and wide frequency tuning range.

In LC based VCOs, phase noise depends primarily on the loaded Q-factor of the resonator circuit and the nonlinearities associated with the tuning network that employ the varactor diodes. The frequency tuning range is determined by the usable capacitive tuning ratio of the varactor diode and the parasitics associated with the tuning network because the parasitics deteriorate and limit the effective tuning capability of the varactor diode at a high frequency.

An example of an LC resonator based voltage-controlled oscillator is disclosed in WO 2006/025670. The VCO circuit of this document includes a first differential amplifier, a second differential amplifier which constitute a differential pair, and a common LC resonator.

The LC resonator circuit of WO 2006/025670 consists of an inductor L and two back-to-back varactor diodes D1, D2. The varactor diode is a device in which reactance changes according to the voltage that is applied. The varactor diode has such an electric characteristic that the characteristic impedance and the resonant frequency of the LC resonator can be changed. Therefore, when an appropriate controlled voltage is applied, the value of an equivalent capacitance in the varactor diode will change.

However, due to the varactor diodes arrangement, the series resistance of the series-connected varactor diodes is high at low applied voltage. Thus, the resonator quality factor Q will be low at low applied voltages, and oscillations might not start at all or start with a signal which has a poor performance concerning phase noise issue. Finally, varactor diodes with low zero-voltage capacitance (Cj0) have normally high series resistance which has additional effect with respect to the quality factor.

Thus, it is an object of the present invention to alleviate the above mentioned disadvantages and to provide a modified LC resonator based voltage-controlled oscillator which, as an example, may be used in wireless communications devices as well as in radio-frequency (RF) test and measurement equipments, and which has improved phase noise characteristics and improved wideband capabilities.

WO 2000/54405 addresses this problem, but proposes a solution based on adjusting the coupling to the resonant circuit to mitigate the varying Q of that resonant circuit through its tuning range.

This object is achieved by a voltage-controlled oscillator having an LC resonator circuit as defined in claim 1, and an LC resonator as defined in claim 8. Preferred embodiments of the voltage-controlled oscillator and of the LC resonator are set out in the corresponding dependent claims.

Accordingly, the present invention provides an LC resonator based voltage-controlled oscillator with improved phase noise and wideband characteristics. This is generally achieved by introducing a combination of inductors (lumped and distributed), capacitors (lumped, distributed as well as varactors) in a certain configuration, whereby the zero voltage capacitance of the varactor diode will be lowered while keeping the same resistance which is dominated by the varactor diode series resistance. Further, the quality factor (Q) will be improved when the varactor diode capacitance or its series resistance is lowered according to the formula $Q = 1/(2 \ast \Pi \ast f \ast C \ast Rs)$,

where *f* is the test frequency, C is the diode capacitance and Rs is the series resistance. In particular, the LC resonator circuit in the VCO of the present invention is formed by a parallel configuration of (a) a microstrip inductor and (b) two series connected varactors in back-to-back arrangement, the connecting point between the varactors is coupled, via an inductor, to a tuning port. One terminal of the parallel configuration is connected to ground, and the other terminal is coupled to the active device of the VCO. Further, as the important feature, each of the varactors is series-connected to an LC unit which consists of parallel connected inductors, wherein one of the inductors is connected to a capacitor in series. By providing series capacitors, the varactor diodes capacitances are lowered, and by means of series inductors, fine adjustment of the frequency to the band of interest is possible.

The modified LC resonator circuit of the present invention will then:

    1. Cover a higher frequency band. The tuning characteristic will change since the effective capacitance-voltage characteristic of the whole circuit will change.

    2. The quality factor (Q) will be higher and consequently the phase noise will be reduced; i.e. Phase noise is inversely proportional to the quality factor (Q)

    3. The circuit will add more degrees of freedom to the whole VCO to change the frequency and the band of interest with low-cost varactor diodes.

The invention will in the following be described in connection with different, non-limiting embodiments shown in the drawings, in which:

    Figure 1 shows a circuit diagram of an exemplary embodiment of a VCO using an LC resonator;

    Figure 2 shows a circuit diagram of a prior art LC resonator used in the VCO of Figure 1;

    Figure 3 shows a circuit diagram of another prior art LC resonator used in the VCO of Figure 1;

    Figure 4 shows a circuit diagram of a prior art LC resonator similar to that of Figure 2;

    Figure 5 shows a circuit diagram of an LC resonator to be used according to the invention in the VCO of Figure 1;

    Figure 6 is a graph of the input reflection coefficient (S11) of the prior art resonator of Fig. 4;

    Figure 7 is a graph of the input reflection coefficient (S11) of the LC resonator of Fig. 5 which is used in the VCO in accordance with the present invention.

In the following detailed description, a reference is made to the accompanying drawings that form part of it, and in which drawings, by way of illustration, specific embodiments of the present invention are shown. Embodiments of the present invention provide improvements in LC resonators for voltage-controlled oscillators which are used in, for example, wireless communication devices such as mobile phones, personal digital assistants (PDA), Bluetooth apparatuses and similar devices.

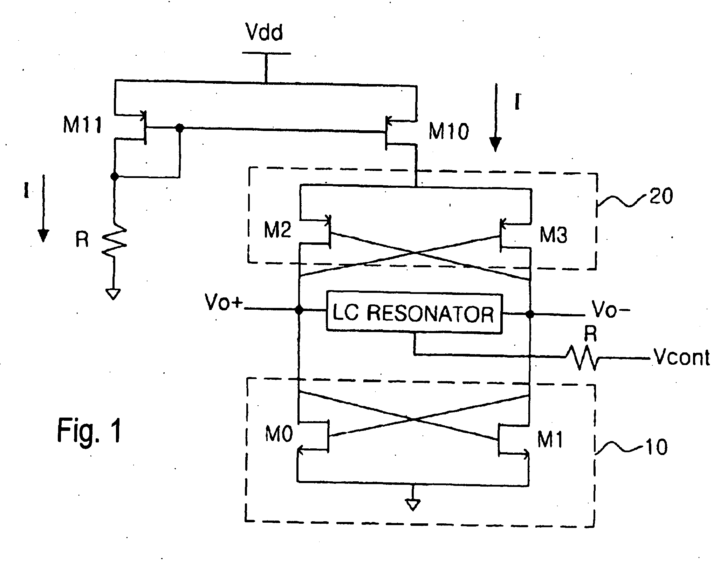

Reference is now made to Figure 1 which shows a circuit diagram of an exemplary embodiment of a conventional voltage-controlled oscillator using an LC resonator. The VCO comprises a first differential amplifier 10 and a second differential amplifier 20. In the first differential amplifier 10, the drain of a first MOSFET M0 is feedback to the gate of a second MOSFET M1, and the drain of the second MOSFET M1 is feedback to the gate of the first MOSFET M0. In the second differential amplifier 20, the drain of a third MOSFET M2 is feedback to the gate of a fourth MOSFET M3, and the drain of the fourth MOSFET M3 is feedback to the gate of the third MOSFET M2.

The first and second differential amplifiers 10, 20 have output ends which are coupled to an LC resonator circuit details of which are described later. MOSFET M11 and MOSFET M10 constitute a current mirror circuit to appropriately supply current to the differential amplifiers. The VCO circuit of Figure 1 is well known in the art. It is noted that the VCO circuit of Figure 1 is merely an example, and many other VCO circuit configurations are possible. The common feature of all possible VCO circuit configurations is the LC resonator.

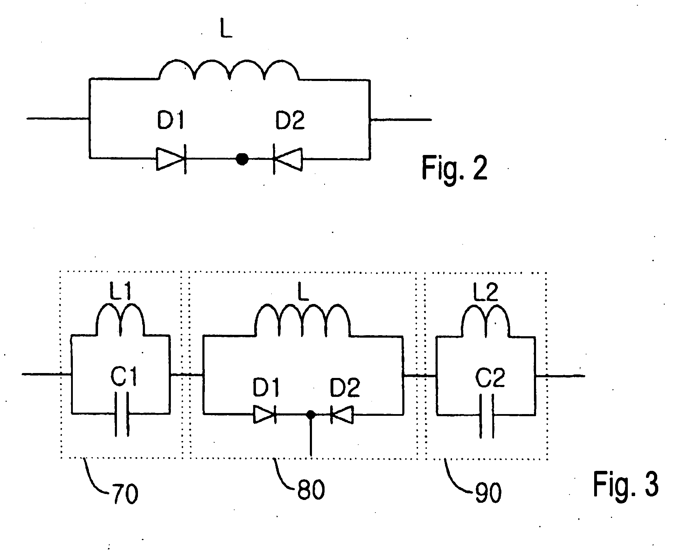

Figure 2 shows a conventional prior art LC resonator as can be used in the VCO circuit of Figure 1 which LC resonator consists of an inductor L and two varactor diodes D1, D2 which are arranged in back-to-back configuration.

Figure 3 shows another embodiment of a prior art LC resonator which can be used in the VCO circuit of Figure 1. The circuit of Figure 3 includes a first resonance circuit 80, a second resonance circuit 70 and a third resonance circuit 90 which resonance circuits 70, 80, 90 are connected in series.

In detail, the first resonance circuit 80 of Figure 2 is identical to the resonance circuit of Figure 1. The second resonance circuit 70 is an oscillation frequency resonance circuit in which inductor L1 and capacitor C1 are connected in parallel. Further, the second resonance circuit 70 is serially connected to a port of the first resonance circuit 80. The third resonance circuit 90 is a third harmonic resonance circuit in which inductor L2 and capacitor C2 are connected in parallel, and wherein the third resonance circuit 90 is serially connected to the other port of the first resonance circuit 80.

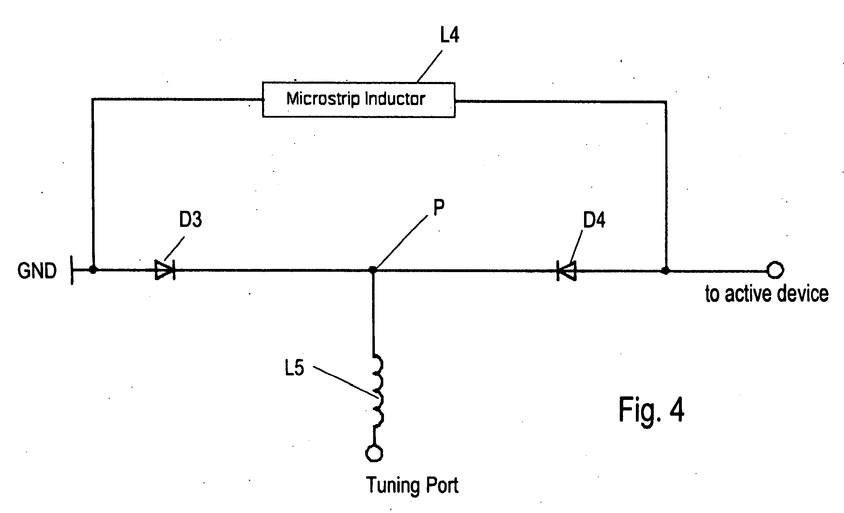

Figure 4 also shows a conventional prior art LC resonator which is similar to that of Figure 2, wherein the LC resonator comprises a microstrip inductor L4 and two varactor diodes D3, D4 which are arranged in back-to-back configuration. Further, the connecting point P between varactor diodes D3, D4 is coupled, via inductor L5, to the tuning port of a VCO circuit as shown, for example, in Figure 1. Finally, the left port (see Figure 4) of the LC resonator circuit is connected to ground (GND), and the opposite right port of the circuit is connected to an active device (not shown).

As mentioned above, also the LC resonator circuit of Figure 4 has the same drawbacks as the circuit of Figure 1 which have already been described in detail.

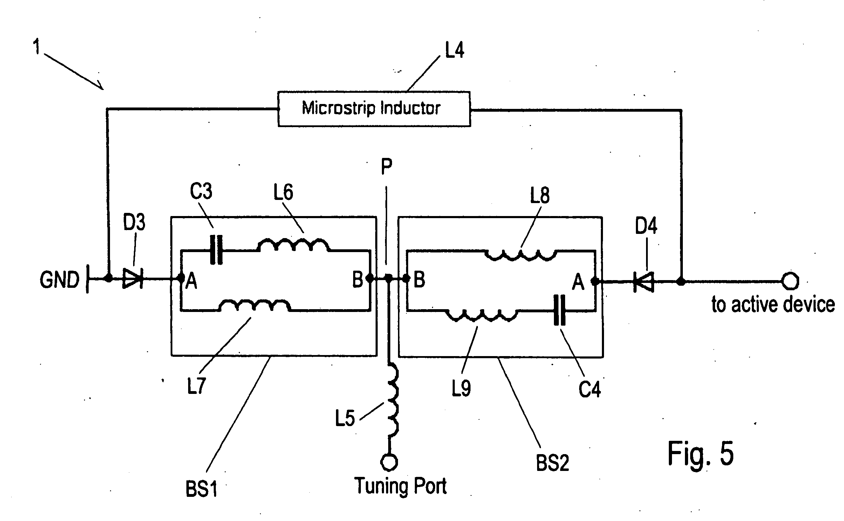

Figure 5 shows the LC resonator circuit 1 according to the present invention. The general structure of this circuit 1 is substantially similar to that of Figures 1 and 4, i.e. the LC resonator 1 comprises a microstrip inductor L4 and, in parallel connection thereto, two varactor diodes D3, D4 which are arranged in back-to-back orientation to each other. Further, the left port (see Figure 5) of the LC resonator circuit 1 is connected to ground (GND), and the opposite right port (see Figure 5) of the LC resonator circuit 1 is connected to an active device (not shown), wherein the active device is an active element of the voltage-controlled oscillator, e.g. BJT or FET or similar active electric components.

The LC resonator circuit 1 of Figure 5 further comprises two band-shifting circuits BS1 and BS2 having first and second terminals A, B, wherein the first terminals A are series-connected to varactor diode D3 and varactor diode D4, respectively, and the second terminals B are connected to a common connection point P which is coupled, via inductor L5, to the tuning port. It is obvious from Figure 5 that the first terminal A of the first band-shifting circuit BS1 is connected to the negative terminal of varactor diode D3, and that the first terminal A of the second band-shifting circuit BS2 is connected to the negative terminal of varactor diode D4. However, other configurations are also possible, i.e. the first terminals A of the first and second band-shifting circuits BS1 and BS2 can also be series-connected to the positive terminal of varactor diodes D3 and D4, respectively.

The first band-shifting circuit BS1 comprises a first inductor L6 which is series-connected to a respective first capacitor C3, wherein this series-configuration of the first inductor L6 and the first capacitor C3 is parallel-connected to a second inductor L7. The configuration of the second band-shifting circuit BS2 is similar to that of the first band-shifting circuit BS1, i.e. a third inductor L9 is series-connected to a respective second capacitor C4, wherein this series-configuration of the third inductor L9 and the second capacitor C4 is parallel-connected to a fourth inductor L8. Preferably, the arrangement of the first and third inductors L6, L9 and the first and second capacitors C3, C4 is such that the capacitors C3, C4 of the first and second band-shifting circuits BS1, BS2 are in direct connection with the first terminal A thereof, and thus, are also in direct connection to the respective varactor diodes D3, D4.

The function of the inductor L5 is to conduct the tuning voltage to the points B. L5 can be a combination of an air conductor and a choke. The function of the inductors L7 and L8 is to conduct the tuning voltage from points B to the negative terminals of the varactor diodes D3 and D4. L7 and L8 are high quality (wire-wound) inductors that have low series resistance to minimize the losses of the whole resonator. Furthermore, their value must be chosen such that the quality factor of the whole resonator is not loaded and at the same time the self-resonance frequency of each of these inductors lies out of the operating frequency band of the VCO. The equivalent capacitance of each of the varactor diodes is reduced through the series connection with the new capacitance introduced in the shifting circuits; i.e. the equivalent capacitance of the varactor diode D3 is now

$$Ceq3 = CD3 * C3/(CD3 + C3)$$

where Ceq3 is the series combination of the varactor diode (D3) capacitance CD3 and C3. In the same way the equivalent capacitance of the varactor diode D3 is now

$$Ceq4 = CD4 * C4/(CD4 + C4)$$

where Ceq4 is the series combination of the varactor diode (D4) capacitance CD4 and C4. The capacitors C3 and C4 are the core of the shifting circuit in which they lower the capacitances of the varactor diodes D3 and D4 according to the above equations, respectively. The inductors L6 and L9 have a fine adjustment effect on the frequency shifting of the frquency shifting circuits BS1 and BS2, respectively.

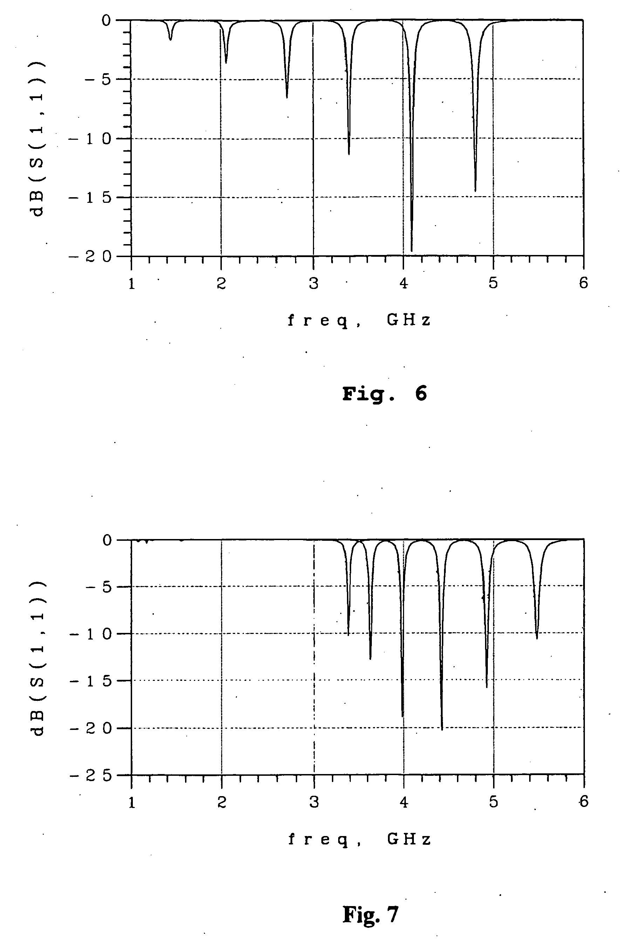

To demonstrate the improvement introduced by the present invention, first the prior art resonator circuit of Figure 4 is simulated to see the resonances. Figure 6 shows these simulation results of the resonator input reflection coeffecient (S11) expressed in dB. It shows that the best results in the phase noise will be within the frequencies between 3.39 GHz and 4.8 GHz. This frequency band which is 1.41 GHz wide has reduced losses than the band below 3.39GHz or above 4.8 GHz.

If the band-shifting circuits are added to the circuit of Figure 4 to be like that of Figure 5 which is to be used in a VCO according to the present invention and simulations are performed again then the new resonator circuit will give better resonances as shown in Figure 7. Figure 7 shows strong resonances between the frequencies 3.38 GHz and 5.48 GHz which corresponds to bandwidth of 2.1 GHz.

**Claims**

1. Voltage controlled oscillator (VCO) having an LC resonator circuit (1), the LC resonator circuit (1) comprises:

   a first varactor diode (D3) having a positive terminal and a negative terminal,
   a second varactor diode (D4) having a positive terminal and a negative terminal,
   a first band-shifting circuit (BS1) series-connected to the first varactor diode (D3),
   a second band-shifting circuit (BS2), series-connected to the second varactor diode (D4),

   wherein the first and second band-shifting circuits (BS1, BS2) are series-connected to each other via a connection point (P),
   **characterized in that**
   the first band-shifting circuit (BS1) comprises first and second inductors (L6, L7), and a first capacitor (C3),
   the second band-shifting circuit (BS2) comprises third and fourth inductors (L9, L8), and a second capacitor (C4),
   the first band-shifting circuit (BS1) comprises a first inductor (L6) which is series-connected to a respective first capacitor (C3), wherein this series-configuration of the first inductor (L6) and the first capacitor (C3) is parallel-connected to a second inductor (L7), and the second band-shifting circuit (BS2) comprises a third inductor (L9) which is series-connected to a respective second capacitor (C4), wherein this series-configuration of the third inductor (L9) and the second capacitor (C4) is parallel-connected to a fourth inductor (L8).

2. Voltage controlled oscillator (VCO) according to claim 1, having an LC resonator circuit (1), the LC resonator circuit (1) further comprises:

   a microstrip inductor (L4) parallel-connected to the series-connected configuration consisting of the first varactor diode (D3), the first band-shifting circuit (BS1), the second band-shifting circuit (BS2), and the second varactor diode (D4).

3. Voltage controlled oscillator (VCO) according to any of the preceding claims, having an LC resonator circuit (1), the LC resonator circuit (1) further comprises:

   a fifth inductor (L5) connected to the connection point (P) for coupling the connection point (P) to the tuning port of the voltage-controlled oscillator.

4. Voltage controlled oscillator (VCO) according to any of the preceding claims, having an LC resonator circuit (1), wherein the first varactor diode (D3) and the second varactor diode (D4) are arranged in back-to-back orientation to each other.

5. Voltage controlled oscillator (VCO) according to any of the preceding claims, having an LC resonator circuit (1), wherein the positive terminal of the first varactor diode (D3) is connected to ground (GND) and the positive terminal of the second varactor diode (D4) is connected to an active device of the voltage-controlled oscillator.

6. Voltage controlled oscillator (VCO) according to any of the preceding claims, having an LC resonator circuit (1), wherein the arrangement of the first and third inductors (L6, L9) and the first and second capacitors (C3, C4) is such that the first and second capacitors of the first and second band-shifting circuits (BS1, BS2) are in direct connection with the first terminal A thereof, and thus, are also in direct connection to the respective varactor diode (D3, D4).

7. LC resonator circuit (1) comprising:

   a first varactor diode (D3) having a positive terminal and a negative terminal,
   a second varactor diode (D4) having a positive terminal and a negative terminal,
   a first band-shifting circuit (BS1) series-connected to the first varactor diode (D3),
   a second band-shifting circuit (BS2), series-connected to the second varactor diode (D4),

   wherein the first and second band-shifting circuits (BS1, BS2) are series-connected to each other via a connection point (P),
   **characterized in that**
   the first band-shifting circuit (BS1) comprises first and second inductors (L6, L7), and a first capacitor (C3),
   the second band-shifting circuit (BS1) comprises third and fourth inductors (L9, L8), and a second capacitor (C4),
   the first band-shifting circuit (BS1) comprises a first inductor (L6) which is series-connected to a respective first capacitor (C3), wherein this series-configuration of the first inductor (L6) and the first capacitor (C3) is parallel-connected to a second inductor (L7), and wherein the second band-shifting circuit (BS2) comprises a third inductor (L9) which is series-connected to a respective second capacitor (C4), wherein this series-configuration of the third inductor (L9) and the second capacitor (C4) is parallel-connected to a fourth inductor (L8).

8. LC resonator circuit (1) according to claim 7 further comprising:

a microstrip inductor (L4) parallel-connected to the series-connected configuration consisting of the first varactor diode (D3), the first band-shifting circuit (BS1), the second band-shifting circuit (BS2), and the second varactor diode (D4).

9.  LC resonator circuit (1) according to claim 7 or claim 8 further comprising:

    a fifth inductor (L5) connected to the connection point (P) for coupling the connection point (P) to the tuning port of a voltage-controlled oscillator.

10. LC resonator circuit (1) according to any of claims 7 to 9, wherein the first varactor diode (D3) and the second varactor diode (D4) are arranged in back-to-back orientation to each other.

11. LC resonator circuit (1) according to any of claims 7 to 10, wherein the positive terminal of the first varactor diode (D3) is connected to ground (GND) and the positive terminal of the second varactor diode (D4) is connected to an active device of a voltage-controlled oscillator.

12. LC resonator circuit (1) according to any of claims 8 to 11, wherein the arrangement of the first and third inductors (L6, L9) and the first and second capacitors (C3, C4) is such that the first and second capacitors of the first and second band-shifting circuits (BS1, BS2) are in direct connection with the first terminal A thereof, and thus, are also in direct connection to the respective varactor diode (D3, D4).

**Patentansprüche**

1.  Spannungsgesteuerter Oszillator (VCO) mit einer LC-Resonatorschaltung (1), wobei die LC-Resonatorschaltung (1) aufweist:

    eine erste Varaktordiode (D3) mit einem positiven Anschluss und einem negativen Anschluss, eine zweite Varaktordiode (D4) mit einem positiven Anschluss und einem negativen Anschluss, eine erste Bandverschiebungsschaltung (BS1), die mit der ersten Varaktordiode (D3) in Reihe geschaltet ist, eine zweite Bandverschiebungsschaltung (BS2), die mit der zweiten Varaktordiode (D4) in Reihe geschaltet ist,

    wobei die erste und die zweite Bandverschiebungsschaltung (BS1, BS2) über einen Verbindungspunkt (P) miteinander in Reihe geschaltet sind, **dadurch gekennzeichnet, dass** die erste Bandverschiebungsschaltung (BS1) eine erste und eine zweite Induktivität (L6, L7) sowie eine erste Kapazität (C3) aufweist, die zweite Bandverschiebungsschaltung (BS2) eine dritte und eine vierte Induktivität (L9, L8) sowie eine zweite Kapazität (C4) aufweist, die erste Bandverschiebungsschaltung (BS1) eine erste Induktivität (L6) aufweist, die mit einer zugehörigen ersten Kapazität (C3) in Reihe geschaltet ist, wobei diese Reihenkonfiguration der ersten Induktivität (L6) und der ersten Kapazität (C3) parallel zu einer zweiten Induktivität (L7) geschaltet ist, und die zweite Bandverschiebungsschaltung (BS2) eine dritte Induktivität (L9) aufweist, die mit einer zugehörigen zweiten Kapazität (C4) in Reihe geschaltet ist, wobei diese Reihenkonfiguration der dritten Induktivität (L9) und der zweiten Kapazität (C4) parallel zu einer vierten Induktivität (L8) geschaltet ist.

2.  Spannungsgesteuerter Oszillator (VCO) nach Anspruch 1, mit einer LC-Resonatorschaltung (1) wobei die LC-Resonatorschaltung (1) außerdem aufweist:

    eine Mikrostreifen-Induktivität (L4), die zu der in Reihe geschalteten Konfiguration parallel geschaltet ist, die die erste Varaktordiode (D3), die erste Bandverschiebungsschaltung (BS1), die zweite Bandverschiebungsschaltung (BS2) und die zweite Varaktordiode (D4) umfasst.

3.  Spannungsgesteuerter Oszillator (VCO) nach einem der vorhergehenden Ansprüche, mit einer LC-Resonatorschaltung (1), wobei die LC-Resonatorchaltung (1) außerdem aufweist:

    eine fünfte Induktivität (L5), die mit dem Verbindungspunkt (P) verbunden ist, um den Verbindungspunkt (P) mit dem Einstellanschluss des spannungsgesteuerten Oszillators zu koppeln.

4.  Spannungsgesteuerter Oszillator (VCO) nach einem der vorhergehenden Ansprüche, mit einer LC-Resonatorschaltung (1), wobei die erste Varaktordiode (D3) und die zweite Varaktordiode (D4) in einer Rücken-an-Rücken-Ausrichtung zueinander angeordnet sind.

5.  Spannungsgesteuerter Oszillator (VCO) nach einem der vorhergehenden Ansprüche, mit einer LC-Resonatorschaltung (1), wobei der positive Anschluss der ersten Varaktordiode (D3) mit Erde (GND) verbunden ist und der positive Anschluss der zweiten Varaktordiode (D4) mit einer aktiven Vorrichtung des spannungsgesteuerten Oszillators verbunden ist.

6.  Spannungsgesteuerter Oszillator (VCO) nach einem der vorhergehenden Ansprüche, mit einer LC-Resonatorschaltung (1), wobei die Anordnung der ersten und der dritten Induktivität (L6, L9) sowie der ersten und der zweiten Kapazität (C3, C4) so ist, dass die erste und die zweite Kapazität der ersten und der zweiten Bandverschiebungsschaltung (BS1, BS2) direkt mit dem ersten Anschluss A davon verbunden sind und daher auch direkt mit der zugehörigen Varaktordiode (D3, D4) verbunden sind.

7. LC-Resonatorschaltung (1) mit:

einer ersten Varaktordiode (D3) mit einem positiven Anschluss und einem negativen Anschluss,
einer zweiten Varaktordiode (D4) mit einem positiven Anschluss und einem negativen Anschluss,
einer ersten Bandverschiebungsschaltung (BS1), die mit der ersten Varaktordiode (D3) in Reihe geschaltet ist,
einer zweiten Bandverschiebungsschaltung (BS2), die mit der zweiten Varaktordiode (D4) in Reihe geschaltet ist,

wobei die erste und die zweite Bandverschiebungsschaltung (BS1, BS2) über einen Verbindungspunkt (P) miteinander in Reihe geschaltet sind, **dadurch gekennzeichnet, dass** die erste Bandverschiebungsschaltung (BS1) eine erste und eine zweite Induktivität (L6, L7) sowie eine erste Kapazität (C3) aufweist, die zweite Bandverschiebungsschaltung (BS2) eine dritte und eine vierte Induktivität (L9, L8) sowie eine zweite Kapazität (C4) aufweist, die erste Bandverschiebungsschaltung (BS1) eine erste Induktivität (L6) aufweist, die mit einer zugehörigen ersten Kapazität (C3) in Reihe geschaltet ist, wobei diese Reihenkonfiguration der ersten Induktivität (L6) und der ersten Kapazität (C3) parallel zu einer zweiten Induktivität (L7) geschaltet ist, und die zweite Bandverschiebungsschaltung (BS2) eine dritte Induktivität (L9) aufweist, die mit einer zugehörigen zweiten Kapazität (C4) in Reihe geschaltet ist, wobei diese Reihenkonfiguration der dritten Induktivität (L9) und der zweiten Kapazität (C4) parallel zu einer vierten Induktivität (L8) geschaltet ist.

8. LC-Resonatorschaltung (1) nach Anspruch 7 außerdem mit:

einer Mikrostreifen-Induktivität (L4), die zu der in Reihe geschalteten Konfiguration parallel geschaltet ist, die die erste Varaktordiode (D3), die erste Bandverschiebungsschaltung (BS1), die zweite Bandverschiebungsschaltung (BS2) und die zweite Varaktordiode (D4) umfasst.

9. LC-Resonatorschaltung (1) nach Anspruch 7 oder nach Anspruch 8, außerdem mit:

einer fünften Induktivität (L5), die mit dem Verbindungspunkt (P) verbunden ist, um den Verbindungspunkt (P) mit dem Einstellanschluss eines spannungsgesteuerten Oszillators zu koppeln.

10. LC-Resonatorschaltung (1) nach einem der Ansprüche 7 bis 9, wobei die erste Varaktordiode (D3) und die zweite Varaktordiode (D4) in einer Rücken-an-Rücken-Ausrichtung zueinander angeordnet sind.

11. LC-Resonatorschaltung (1) nach einem der Ansprüche 7 bis 10, wobei der positive Anschluss der ersten Varaktordiode (D3) mit Erde (GND) verbunden ist und der positive Anschluss der zweiten Varaktordiode (D4) mit einer aktiven Vorrichtung des spannungsgesteuerten Oszillators verbunden ist.

12. LC-Resonatorschaltung (1) nach einem der Ansprüche 7 bis 11, wobei die Anordnung der ersten und der dritten Induktivität (L6, L9) sowie der ersten und der zweiten Kapazität (C3, C4) so ist, dass die erste und die zweite Kapazität der ersten und der zweiten Bandverschiebungsschaltung (BS1, BS2) direkt mit dem ersten Anschluss A davon verbunden sind und daher auch direkt mit der zugehörigen Varaktordiode (D3, D4) verbunden sind.

## Revendications

1. Oscillateur commandé en tension (VCO) comportant un circuit LC résonant (1), le circuit LC résonant comprenant :

une première diode à capacité variable (D3) ayant une borne positive et une borne négative, une deuxième diode à capacité variable (D4) ayant une borne positive et une borne négative, un premier circuit de décalage de bande (BS1) connecté en série avec la première diode à capacité variable (D3), un deuxième circuit de décalage de bande (BS2) connecté en série avec la deuxième diode à capacité variable (D4),

dans lequel les premier et deuxième circuits de décalage de bande (BS1, BS2) sont connectés en série entre eux via un point de connexion (P), **caractérisé en ce que** :

le premier circuit de décalage de bande (BS1) comprend des première et deuxième inductances (L6, L7) et un premier condensateur (C3), le deuxième circuit de décalage de bande (BS2) comprend des troisième et quatrième inductances (L9, L8) et un deuxième condensateur (C4), le premier circuit de décalage de bande (BS1) comprend une première inductance (L6) qui est connectée en série avec un premier condensateur respectif (C3), cette configuration en série de la première inductance (L6) et du premier condensateur (C3) étant montée en parallèle à une deuxième inductance (L7), et le deuxième circuit de décalage de bande (BS2) comprend une troisième inductance (L9) qui est connectée en série avec un deuxième condensateur respectif (C4), cette configuration en série de la troisième inductance (L9) et du deuxième condensateur (C4) étant montée en parallèle à une quatrième inductance (L8).

2.  Oscillateur commandé en tension (VCO) selon la revendication 1, comportant un circuit LC résonant (1), le circuit LC résonant (1) comprenant en outre :

    une inductance à microruban (L4) connectée en parallèle à la configuration série constituée de la première diode à capacité variable (D3), du premier circuit de décalage de bande (BS1), du deuxième circuit de décalage de bande (BS2) et de la deuxième diode à capacité variable (D4).

3.  Oscillateur commandé en tension (VCO) selon l'une quelconque des revendications précédentes, comportant un circuit LC résonant (1), le circuit LC résonant (1) comprenant en outre :

    une cinquième inductance (L5) connectée au point de connexion (P) pour coupler le point de connexion (P) au point d'accès d'accord de l'oscillateur commandé en tension.

4.  Oscillateur commandé en tension (VCO) selon l'une quelconque des revendications précédentes, comportant un circuit LC résonant (1), dans lequel la première diode à capacité variable (D3) et la deuxième diode à capacité variable (D4) sont disposées dos à dos l'une par rapport à l'autre.

5.  Oscillateur commandé en tension (VCO) selon l'une quelconque des revendications précédentes, comportant un circuit LC résonant (1), dans lequel la borne positive de la première diode à capacité variable (D3) est connectée à la masse (GND) et la borne positive de la deuxième diode à capacité variable (D4) est connectée à un dispositif actif de l'oscillateur commandé en tension.

6.  Oscillateur commandé en tension (VCO) selon l'une quelconque des revendications précédentes, comportant un circuit LC résonant (1), dans lequel l'agencement des première et troisième inductances (L6, L9) et des premier et deuxième condensateurs (C3, C4) est tel que les premier et deuxième condensateurs des premier et deuxième circuits de décalage de bande (BS1, BS2) sont en connexion directe avec leur première borne A, et sont donc aussi en connexion directe avec la diode à capacité variable respective (D3, D4).

7.  Circuit LC résonant (1) comprenant :

    une première diode à capacité variable (D3) ayant une borne positive et une borne négative, une deuxième diode à capacité variable (D4) ayant une borne positive et une borne négative, un premier circuit de décalage de bande (BS1) connecté en série avec la première diode à capacité variable (D3), un deuxième circuit de décalage de bande (BS2) connecté en série avec la deuxième diode à capacité variable (D4),

    dans lequel les premier et deuxième circuits de décalage de bande (BS1, BS2) sont connectés en série entre eux via un point de connexion (P), **caractérisé en ce que** :

    le premier circuit de décalage de bande (BS1) comprend des première et deuxième inductances (L6, L7) et un premier condensateur (C3), le deuxième circuit de décalage de bande (BS2) comprend des troisième et quatrième inductances (L9, L8) et un deuxième condensateur (C4), le premier circuit de décalage de bande (BS1) comprend une première inductance (L6) qui est connectée en série avec un premier condensateur respectif (C3), cette configuration en série de la première inductance (L6) et du premier condensateur (C3) étant montée en parallèle à une deuxième inductance (L7), et dans lequel le deuxième circuit de décalage de bande (BS2) comprend une troisième inductance (L9) qui est connectée en série avec un deuxième condensateur respectif (C4), cette configuration en série de la troisième inductance (L9) et du deuxième condensateur (C4) étant montée en parallèle à une quatrième inductance (L8).

8.  Circuit LC résonant (1) selon la revendication 7, comprenant en outre une inductance à microruban (L4) connectée en parallèle à la configuration série constituée de la première diode à capacité variable (D3), du premier circuit de décalage de bande (BS1), du deuxième circuit de décalage de bande (BS2) et de la deuxième diode à capacité variable (D4).

9.  Circuit LC résonant (1) selon la revendication 7 ou 8, comprenant en outre une cinquième inductance (L5) connectée au point de connexion (P) pour coupler le point de connexion (P) au point d'accès d'accord d'un oscillateur commandé en tension.

10. Circuit LC résonant (1) selon l'une quelconque des revendications 7 à 9, dans lequel la première diode à capacité variable (D3) et la deuxième diode à capacité variable (D4) sont disposées dos à dos l'une par rapport à l'autre.

11. Circuit LC résonant (1) selon l'une quelconque des revendications 7 à 10, dans lequel la borne positive de la première diode à capacité variable (D3) est connectée à la masse (GND) et la borne positive de la deuxième diode à capacité variable (D4) est connectée à un dispositif actif d'un oscillateur commandé en tension.

12. Circuit LC résonant (1) selon l'une quelconque des revendications 8 à 11, dans lequel l'agencement des première et troisième inductances (L6, L9) et des premier et deuxième condensateurs (C3, C4) est tel que les premier et deuxième condensateurs des premier et deuxième circuits de décalage de bande (BS1, BS2) sont en connexion directe avec leur première borne A, et sont donc aussi en connexion directe avec la diode à capacité variable respective (D3, D4).

Fig. 1

Fig. 2

Fig. 3

EP 1 898 520 B1

Fig. 4

EP 1 898 520 B1

Fig. 5

EP 1 898 520 B1

**Fig. 6**

**Fig. 7**

**EP 1 898 520 B1**

**Patent documents cited in the description**

- WO 2006025670 A

- WO 200054405 A